# EUROPEAN PATENT APPLICATION

(11) **EP 3 961 526 A1**
(43) Date of publication of application: **02.03.2022**
(21) Application number: 20020387.5
(22) Date of filing: 26.08.2020
(51) Int. Cl.: G06Q 10/06, G06Q 50/02, B65G 3/02

(54) **A METHOD FOR DYNAMICALLY CONSTRUCTING AND UPDATING A MODEL OF 3D TOPOGRAPHY OF A STOCK-PILE OF GRANULAR MATERIAL**

(71) Applicant: IntelliSense.io Limited, Cambridge CB5 8DT (GB)
(72) Inventor: Knoblauch, Niel, Cambridge, CB5 8DT (GB); Kopec, Grant, Cambridge, CB5 8DT (GB); Murray, Éamonn, Cambridge, CB5 8DT (GB); McNamara, Hugh, Cambridge, CB5 8DT (GB); De Geus, Marc, Cambridge, CB5 8DT (GB); Laborde, Cecilia, Cambridge, CB5 8DT (GB); Hallson, Chris, Cambridge, CB5 8DT (GB); Gatica, Marion Leo, Cambridge, CB5 8DT (GB)
(74) Representative: Basck Ltd

(57) **Abstract**

Disclosed is a method for dynamically constructing and updating a model of 3-dimensional topography of a stock-pile of granular material is provided. The method includes dumping the granular material to a maximum slope in a column in the stock-pile, wherein the maximum slope is determined by analyzing digital scans of the stock-pile; reducing the maximum slope to a smaller value of the maximum slope, dynamically increasing the maximum slope linearly until it reaches the original value of the maximum slope to obtain a uniformly expanding plateau; defining an adjustable shape comprising a first distance and a second distance, wherein the adjustable shape is flat till the first distance and the second distance beyond which the adjustable shape varies with the maximum slope; and reclaiming the granular material that flows downhill from a center depth to update the model of the 3D topography of the stock-pile.

## Description

### TECHNICAL FIELD

The present disclosure generally relates to updating a model of 3-dimensional topography; and more specifically, to a method and system of dynamically constructing and updating a model of 3-dimensional topography of a stock-pile of a granular material.

### DESCRIPTION OF THE RELATED ART

In mining processes, stockpiling strategies are used for different purposes. The different purposes include storing when a mined material does not have right properties to be processed at a particular time, buffering to avoid impacts in mining during emergency situations where a plant must stop or vice versa or when mining capacity is higher than plant processing capacity, blending to blend mined material of different grade contents or due to reduced variance in plant feed and heap leaching to other mining processes to extract valuable minerals from ore. Knowing the contents of each stockpile and how the contents distribute across the stockpile regardless of its purpose has a high relevance for optimizing usage of the stockpiles and its impact in the mining processes. In order to model the stockpiles, different sources of information are required, the minimum requirement being physical and geological properties of the material dumped on the stockpiles. Such information is provided by 3D block models of an ore body before it has been mined. Significant effort has been devoted to develop comprehensive 3D models that provide an accurate overview of the reserves and resources available on site.

However, progress towards developing accurate 3D models of the stockpiles where the material is deposited has been challenged by the complexity of the problem. A major problem arises due to a lack of an accurate 3D stockpile model and costs a big loss of information that comes from a mine 3D block model. This undermines the different purposes of the stockpiles as well as the possibility of tracking the material transport across the full mining process. The problem is further complicated due to a large uncertainty and poor quality of the data sources (mine 3D block model, fleet management system data, topography measurements) and complexity of material dynamics when the material is dumped or reclaimed.

Traditional approaches include discrete element method, molecular dynamics, cellular automata, montecarlo simulations. Even though the traditional approaches render accurate simulations of particles the material as well as bulk behavior, they are computationally expensive for a real-time application.

Therefore, in light of the foregoing discussion, there exists a need to overcome the aforementioned drawbacks of the traditional solutions being computationally expensive and being manual.

### SUMMARY

The present disclosure seeks to provide a method and system of dynamically constructing and updating a model of 3-dimensional topography of a stock-pile of a granular material.

In one aspect, an embodiment of the present disclosure provides a method for dynamically constructing and updating a model of a 3D topography of a stock-pile of the granular material, the method comprising the steps of (i) retrieving a digital scan of the stock-pile at a software using a network, wherein the digital scan is recorded by a scanning device at the stock-pile, (ii) dumping the granular material to a maximum slope in a column in the stock-pile, wherein the maximum slope is determined by analyzing digital scans of the stock-pile, (iii) reducing the maximum slope to a smaller value of the maximum slope based on a distance between the column and a first column that is used to initially dump the granular material, (iv) dynamically increasing the maximum slope linearly until it reaches an original value of the maximum slope to obtain a uniformly expanding plateau, (v) defining an adjustable shape comprising a first distance and a second distance, wherein the adjustable shape is flat till the first distance and the second distance beyond which the adjustable shape varies with the maximum slope, and, (vi) dynamically updating the model of the 3D topography of the stock-pile by reclaiming the granular material that flows downhill from a center depth.

In another aspect, an embodiment of the present disclosure provides a system of dynamically constructing and updating a model of a 3D topography of a stock-pile of a granular material, the system comprising (i) a network that is at least one of a wireless network or a wired network, (ii) a scanning device connected to the network that is configured to record a digital scan of a location that comprises the stockpile and transmit the digital scan in the network, and, (iii) a software connected to the network that comprises (a) a dumping module configured to retrieve a digital scan of the stock-pile at a software, wherein the digital scan is recorded by a scanning device at the stock-pile, dumps a granular material to the maximum slope in a column in the stock-pile, wherein the maximum slope is determined by analyzing digital scans of the stock-pile, reduces the maximum slope to a smaller value of the maximum slope based on a distance between the column and a first column that is used to initially dump the granular material and dynamically increasing the maximum slope linearly until it reaches an original value of the maximum slope to obtain a uniformly expanding plateau, the dumping module further comprising a maximum slope module to determine the maximum slope in the stock-pile and (b) a reclaiming module configured to define an adjustable shape comprising a first distance and a second distance, wherein the adjustable shape is flat till the first distance and the second distance beyond which the adjustable shape varies with the maximum slope and dynamically updating the model of the 3D topography of the stock-pile by reclaiming the granular material that flows downhill from a center depth, the reclaiming module further comprising a center depth module that determines the center depth to reclaim material from the stockpile.

Embodiments of the present disclosure substantially eliminate or at least partially address the aforementioned problems in the prior art, and enables automation, autonomous operation and autonomous optimization while being computationally inexpensive.

Additional aspects, advantages, features and objects of the present disclosure would be made apparent from the drawings and the detailed description of the illustrative embodiments construed in conjunction with the appended claims that follow.

It will be appreciated that features of the present disclosure are susceptible to being combined in various combinations without departing from the scope of the present disclosure as defined by the appended claims.

### BRIEF DESCRIPTION OF THE DRAWINGS

The summary above, as well as the following detailed description of illustrative embodiments, is better understood when read in conjunction with the appended drawings. For the purpose of illustrating the present disclosure, exemplary constructions of the disclosure are shown in the drawings. However, the present disclosure is not limited to specific methods and instrumentalities disclosed herein. Moreover, those in the art will understand that the drawings are not to scale. Wherever possible, like elements have been indicated by identical numbers

Embodiments of the present disclosure will now be described, by way of example only, with reference to the following diagrams wherein:
FIG. 1 is a schematic illustration of a system view of dynamically constructing and updating a model of 3-dimensional topography of a stock-pile of a granular material, in accordance with an embodiment of the present disclosure;
FIG. 2 is a schematic illustration of an exploded view of a digital stockpile system of FIG. 1, in accordance with an embodiment of the present disclosure;
FIGS. 3A and 3B are schematic illustrations of a flow diagram of a method of dynamically constructing and updating a model of 3-dimensional topography of a stock-pile of a granular material, in accordance with an embodiment of the present disclosure;
FIG. 4 is a schematic illustration of a flow diagram of a method of determining the maximum slope in the stock-pile, in accordance with an embodiment of the present disclosure; and
FIGS. 5A and 5B are schematic illustrations of a flow diagram of a method determining a center depth to reclaim material from the stockpile, in accordance with an embodiment of the present disclosure.

In the accompanying drawings, an underlined number is employed to represent an item over which the underlined number is positioned or an item to which the underlined number is adjacent. A non-underlined number relates to an item identified by a line linking the non-underlined number to the item. When a number is non-underlined and accompanied by an associated arrow, the non-underlined number is used to identify a general item at which the arrow is pointing.

### DETAILED DESCRIPTION OF EMBODIMENTS

The following detailed description illustrates embodiments of the present disclosure and ways in which they can be implemented. Although some modes of carrying out the present disclosure have been disclosed, those skilled in the art would recognize that other embodiments for carrying out or practicing the present disclosure are also possible.

In one aspect, an embodiment of the present disclosure provides a method for dynamically constructing and updating a model of a 3D topography of a stock-pile of a granular material, the method comprising the steps of (i) retrieving a digital scan of the stock-pile at a software using a network, wherein the digital scan is recorded by a scanning device at the stock-pile, (ii) dumping the granular material to a maximum slope in a column in the stock-pile, wherein the maximum slope is determined by analyzing digital scans of the stock-pile, (iii) reducing the maximum slope to a smaller value of the maximum slope based on a distance between the column and a first column that is used to initially dump the granular material, (iv) dynamically increasing the maximum slope linearly until it reaches an original value of the maximum slope to obtain a uniformly expanding plateau, (v) defining an adjustable shape comprising a first distance and a second distance, wherein the adjustable shape is flat till the first distance and the second distance beyond which the adjustable shape varies with the maximum slope, and, (vi) dynamically updating the model of the 3D topography of the stock-pile by reclaiming the granular material that flows downhill from a center depth. The method enables automation, autonomous operation and autonomous optimization of the stockpiling process as traditionally the stockpiling process is done by means of manual operation.

A stockpile is a pile or storage location for bulk materials, forming part of the bulk material handling process. The stockpile is normally created by a stacker. A reclaimer is used to recover the material. Stockpiles are normally stacked in stockyards in refineries, ports and mine sites. A stacker is a large machine whose function is to pile bulk material. A reclaimer is a large machine used in bulk material handling applications whose function is to recover bulk material such as ores and cereals from a stockpile. A granular material is a conglomeration of discrete solid, macroscopic particles.

To dynamically model the stockpile, a grid is used in an implicit manner, without creating an empty grid and populating it. When the material is to be added to the location, a column to which the material is to be added is determined from coordinates in the horizontal grid. A label is set for the column to use for the internal state, with new columns created only when necessary, and material added to the column when the column already exists. The column stores contents of a list of cells, with new cells added to the end of the list as needed. Each cell on the list of cells stores a list of dumped batches inside the cell as well as the relative fraction of each of the dumped batches within the cell. The dumping module may dump the granular material to a maximum slope in the column in the stock-pile. Dumping the granular material to the maximum slope uses a physical basis that stacked granular material will slip down until it conforms to some maximum slope. The physical basis is set by setting an upper limit on the slope of a column of material with respect to its surrounding eight columns.

In another aspect, an embodiment of the present disclosure provides a method of determining the maximum slope in the stock-pile, the method comprising the steps of (i) slope in the stock-pile is determined by determining the column from coordinates of a horizontal grid at the stock-pile, wherein the column comprises a plurality of cells, wherein the plurality of cells comprise a list of dumped batches and a fraction of dumped batches, (ii) setting the maximum slope for the column that varies with a distance between the column and an initial dump column, wherein the maximum slope is determined with respect to eight surrounding columns, (iii) obtaining the maximum slope in the stock-pile by determining a distance of the column from the initial dump column. Maximum slope stacking ensures that the creation of an expanding smooth plateau is being replicated. It also ensures that maximum amount of material added to a column is governed by observed physical limits.

In an embodiment, the method of determining the maximum slope further comprises first reduces a value of the maximum slope of the column that is near to the location and increases the value linearly until the value reaches an original value of the maximum slope. Parameters that are involved may be optimized based on the digital scans and historical data. This ensures that dumped material that has fallen below dump height is set to the maximum slope more quickly than any traditional method.

In an embodiment, an algorithm may be used for the chunk process. The algorithm may include the steps of (a) processing a smaller chunk from dumped weight, where value for chunk may be set at 10 tonnes by default, (b) converting the chunk to a volume using a configured density, (c) selecting a nearest column which is closest to the dump location, (d) calculating the maximum slope for the column, where the maximum slope varies linearly with distance, up to a maximum value, (e) calculating a quantity of material to add to the column before value of the slope of the column exceeds the maximum slope, (f) adding the material to the column and adding the remaining amount of the material to a neighboring column having lowest height by dividing the remaining amount of the material equally when there is more than one at the height, (g) repeating steps (c) to (d) until the dumped weight is null, and, (h) repeating steps (a) to (g) until each of the one or more smaller chunks are processed. The chunk process ensures numerical accuracy in the algorithm.

In another aspect, an embodiment of the present disclosure provides a method of determining the center depth to reclaim material from the stockpile, the method comprising the steps of (i) determining a depth in the stockpile at which a reclaimed weight matches a recorded weight, (ii) determining a total column height by converting a weight to a volume using a configured density of the stockpile, (iii) calculating a distance between each column in the stockpile and a center column in the stockpile and a height of material in the stockpile for a given center depth, (iv) determining a column depth at which material is reclaimed at the center column by using a function that determines a reclaiming shape to obtain bracketed values of the center depth, and, (v) obtaining the center depth to reclaim material from the stockpile by determining zero of the function based on the bracketed values using brent's method. The method of determining the center depth causes the reclaiming of the dumped material to be performed in a smooth manner.

In an embodiment, the adjustable shape may be an inverted cone shape having a truncated point. In an embodiment, the adjustable shape is defined using a first and a second distance. Within the first distance, the adjustable shape is flat. Outside the second distance, the adjustable shape varies with the maximum slope. In a region between the two distances, the adjustable shape may be connected smoothly with a quadratic variation. The adjustable shape sets a depth versus distance from a reclaim location and above the depth, all material may be removed. This causes the reclaiming of the dumped material to be performed in a smooth manner.

In an embodiment, a test flag may be used to return batches that would be removed, without modifying the stockpile. In an embodiment, the center depth module may implement a center depth algorithm to determine the center depth. The center depth algorithm includes the steps of (a) finding the depth at which a reclaimed weight matches a recorded weight, (b) converting the reclaimed weight to a volume using a configured density, and to a total column height of material, (c) calculate a distance of each column in the stockpile from a center column, (d) calculating a depth above which all material is reclaimed relative to the center depth for the column using a function that defines reclaiming shape, (e) calculating for a given center depth a total height of material across the whole stockpile, (f) bracketing a correct depth using the steps (b) to (d) by starting from 0 value of the depth, increasing the configured weight if the total material height is too large and decreasing value of the configured weight if the total material height is too low to obtain bracketed values, and (g) determining zero of the function based on the bracketed values using brent's method. In an embodiment, the depth at the center is found by matching the depth to a recorded reclaimed weight. In an embodiment, the bracketed values to are passed to a python module named "scipy.optimize.brentq" that implements brent's method to find the zero of the function to obtain the center depth. The center depth algorithm causes the reclaiming of the dumped material to be performed in a smooth manner.

In an embodiment, either a stockpiling map that illustrates the maximum slope that is acceptable, or, a stopping map that defines the maximum slope that is acceptable may be generated using the steps of: (a) moving to each column in the stockpile, (b) determining a depth at which the material is to be extracted, (c) removing cells above the depth that are full and adding to a set of reclaimed batches, and (d) for a cell that intersects the depth, subtracting material proportionally from one or more batches in the cell to match subsequent height of the column the depth. The steps (a) and (b) are a look-up action performed by a mining operating system or a stacker. The steps (c) and (d) are filter actions for a software that block the software from reading or removing data from the software. The stockpiling map or the stopping map may be transmitted to the mining operating system or a stacker that automatically prevents the next dumping of the material on the top of that column after the maximum slope has been achieved.

In another aspect, an embodiment of the present disclosure provides a processor based method of dynamically updating a model of a 3D topography of a stock-pile location, the method comprising (i) retrieving a digital scan of a stock-pile using a network, wherein the digital scan is recorded by a scanning device at the stock-pile that comprises a horizontal grid, the horizontal grid further comprising one or more columns that are used to dump the granular material to a maximum slope in the stock-pile, the one or more columns lying between eight surrounding columns, wherein the one or more columns further comprise a list of cells that comprises information about a set of batches that are dumped into the one or more columns, and, (ii) a software that performs the steps of (a) dumping the granular material to the maximum slope in a column in the stock-pile, wherein the maximum slope is determined by analyzing digital scans of the stock-pile, (b) dumping the granular material to the maximum slope in a column in the stock-pile, wherein the maximum slope is determined by analyzing digital scans of the stock-pile, (c) reducing the maximum slope to a smaller value of the maximum slope based on a distance between the column and a first column that is used to initially dump the granular material, (d) dynamically increasing the maximum slope linearly until it reaches the original value of the maximum slope to obtain a uniformly expanding plateau, (e) defining an adjustable shape comprising a first distance and a second distance, wherein the adjustable shape is flat till the first distance and the second distance beyond which the adjustable shape varies with the maximum slope, and, (f) reclaiming the granular material that flows downhill from a center depth to update the model of the 3D topography of the stock-pile. The processor based method enables automation, autonomous operation and autonomous optimization of stockpiling process while being computationally inexpensive.

In another aspect, an embodiment of the present disclosure provides a system of dynamically constructing and updating a model of a 3D topography of a stock-pile of a granular material, the system comprising (i) a network that is at least one of a wireless network or a wired network, (ii) a scanning device connected to the network that is configured to record a digital scan of a location that comprises the stockpile and transmit the digital scan in the network, and, (iii) a software connected to the network that comprises (a) a dumping module configured to retrieve a digital scan of the stock-pile at a software, wherein the digital scan is recorded by a scanning device at the stock-pile, dumps a granular material to the maximum slope in a column in the stock-pile, wherein the maximum slope is determined by analyzing digital scans of the stock-pile, reduces the maximum slope to a smaller value of the maximum slope based on a distance between the column and a first column that is used to initially dump the granular material and dynamically increasing the maximum slope linearly until it reaches an original value of the maximum slope to obtain a uniformly expanding plateau, the dumping module further comprising a maximum slope module to determine the maximum slope in the stock-pile and (b) a reclaiming module configured to define an adjustable shape comprising a first distance and a second distance, wherein the adjustable shape is flat till the first distance and the second distance beyond which the adjustable shape varies with the maximum slope and dynamically updating the model of the 3D topography of the stock-pile by reclaiming the granular material that flows downhill from a center depth, the reclaiming module further comprising a center depth module that determines the center depth to reclaim material from the stockpile. The scanning device may include an unmanned aerial vehicle such as a drone that is equipped with one or more sensors that enable the scanning device to take digital scan of the stockpile.

Embodiments of the present disclosure substantially eliminate or at least partially address the aforementioned problems in the prior art, and enables automation, autonomous operation and autonomous optimization while being computationally inexpensive.

The present disclosure provides a method and system of dynamically constructing and updating a model of 3-dimensional topography of a stock-pile of a granular material that enables automation, autonomous operation and autonomous optimization while being computationally inexpensive. The dumped material results in being relatively flat where it is first dumped. The dumped material that has fallen below the dump height is set to the maximum slope more quickly than any traditional method. Maximum slope stacking ensures that the creation of an expanding smooth plateau is not being replicated. Reclaiming of the dumped material is done in a smooth manner.

### DETAILED DESCRIPTION OF THE DRAWINGS

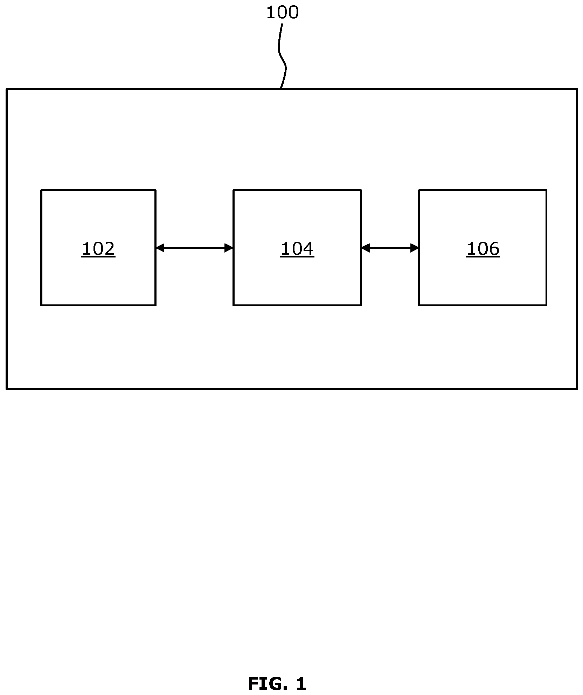

Referring to FIG. 1, illustrated is a schematic illustration of a system view **100** of dynamically constructing and updating a model of 3-dimensional topography of a stock-pile of a granular material in accordance with an embodiment of the present disclosure. The system view **100** includes a scanning device **102**, a network **104** and a digital stockpile system **106.** The scanning device **102** records a digital scan of a stockpile. The scanning device **102** may include an unmanned aerial vehicle such as a drone that is equipped with one or more sensors that enable the scanning device **102** to take digital scan of the stockpile. In an embodiment, the one or more sensors, without limitation, are selected from a light detection and ranging sensor or a laser topographic sensor. The scanning device **102** is connected to the digital stockpile system **106** through the network **104.** The network **104** may be a wired network, a wireless network or a combination of a wired network and a wireless network. In an embodiment, the network **104** is the Internet. The digital stockpile system **106** retrieves the digital scan as real-time data from the scanning device **102** through the network **104** and performs a method of dynamically constructing and updating a model of 3-dimensional topography of a stock-pile of a granular material. The digital stockpile system **106** may be configured to display or retrieving information into a remote display using the network **104.**

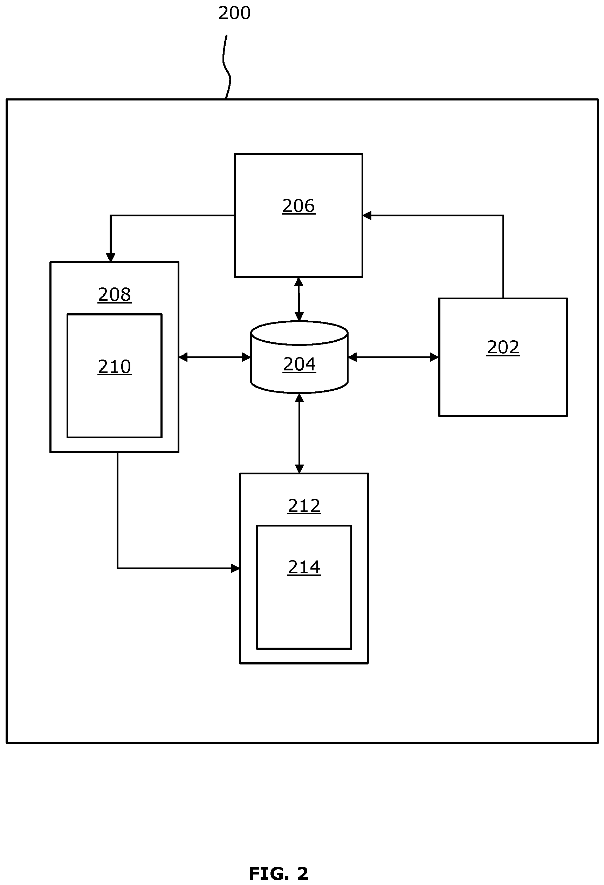

Referring to FIG. 2, illustrated is a schematic illustration of an exploded view **200** of the digital stockpile system **106** of FIG. 1 in accordance with an embodiment of the present disclosure. The digital stockpile system **106** includes a data aggregation module **202,** a database **204,** a dumping module **206**, a maximum slope stacking module **208**, a slope drop-off module **210**, a reclaiming module **212** and a center depth module **214.** The data aggregation module **202** receives real-time data from the scanning device **102.** It may also receive historical data from one or more sources, which may include digital scans of the stockpile associated with intermediate events that occur in the method of dynamically constructing and updating the model of 3-dimensional topography of the stock-pile of the granular material. The database **204** is used by the data aggregation module **202** to store data which is aggregated by the data aggregation module **202.** The maximum slope stacking module **208** determines the maximum slope by analyzing the digital scans of the stockpile.

The maximum slope stacking module **208** comprises the slope drop-off module **210** that reduces the maximum slope to a smaller value of the maximum slope based on a distance between the column and a first column that is used to initially dump the granular material. The maximum slope stacking module **208** dynamically increases the value of the maximum slope linearly until it reaches the original value of the maximum slope to obtain a uniformly expanding plateau. The maximum slope stacking module **208** determines the maximum slope in the stockpile by determining the column from coordinates of a horizontal grid at the stock-pile, setting the maximum slope for the column that varies with a distance between the column and an initial dump column, where the maximum slope is determined with respect to eight surrounding columns and determining a distance of the column from the initial dump column.

When the material is added to the column, the material is processed by the dumping module **206** using a chunk process that processes the material in one or more smaller chunks. Further in the chunk process, for each of the one or more smaller chunks, the dumping module **206** is configured to calculate a value of the material that can be kept in the column before a slope to eight immediate neighboring columns exceeds a set value. After adding the material, a remaining amount of the material may be divided evenly among the eight immediate neighboring materials which cause the eight immediate neighboring materials to be at the maximum slope. In an embodiment, the chunk process is repeated for each of a subsequent column that receives the material. Downhill flow of the material is simulated under an evolving topography of the stockpile. In an embodiment, the value to choose for the maximum slope may be found by analyzing provided stockpile scans.

The reclaiming module **212** reclaims the granular material that flows downhill from a center depth to update the model of the 3D topography of the stockpile. The reclaiming module **212** may extract an intersection of the adjustable shape with the stockpile, which is based on physical basis that material that is stacked comprises some maximum slope after which the material will flow downhill, and that material that may flow downhill is added to the reclaimed material. The reclaiming module **212** defines an adjustable shape comprising a first distance and a second distance, wherein the adjustable shape is flat till the first distance and the second distance beyond which the adjustable shape varies with the maximum slope.

The reclaiming module **212** further includes the center depth module **214** that determines the center depth to reclaim the material from the stockpile by determining a depth in the stockpile at which a reclaimed weight matches a recorded weight, determining a total column height by converting a weight to a volume using a configured density of the stockpile, calculating a distance between each column in the stockpile and a center column in the stockpile and a height of material in the stockpile for a given center depth, determining a column depth at which material is reclaimed at the center column by using a function that determines a reclaiming shape to obtain bracketed values of the center depth, and determining zero of the function based on the bracketed values using brent's method. In an embodiment, the depth at the center is found by matching the depth to a recorded reclaimed weight.

The reclaiming module **212** uses the center depth for each column in the stockpile to reclaim the in the stockpile by removing each cell that is full to a capacity of the cell and added to a set of reclaimed batches. In an embodiment, for the cell that intersects the depth, the material is removed from the batches contained in the cell in a proportional manner to match the final column height with the center depth.

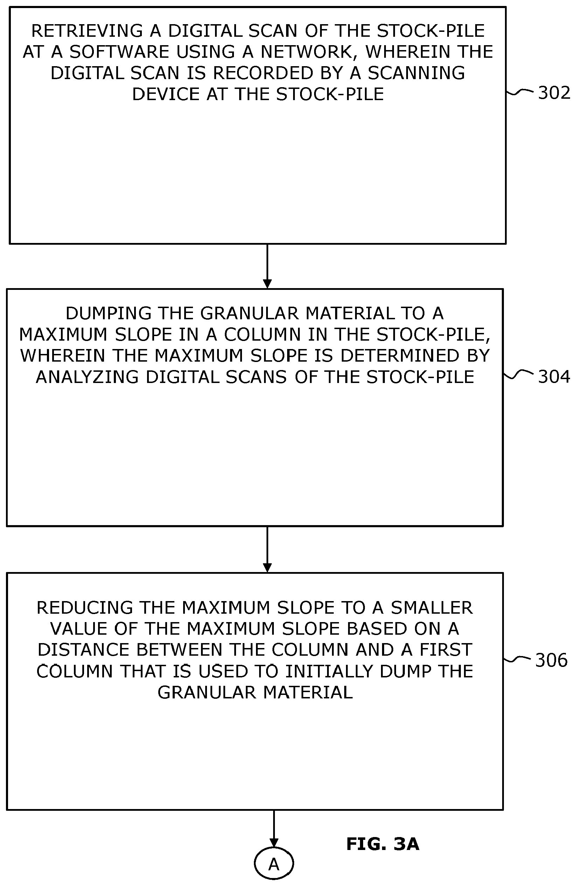

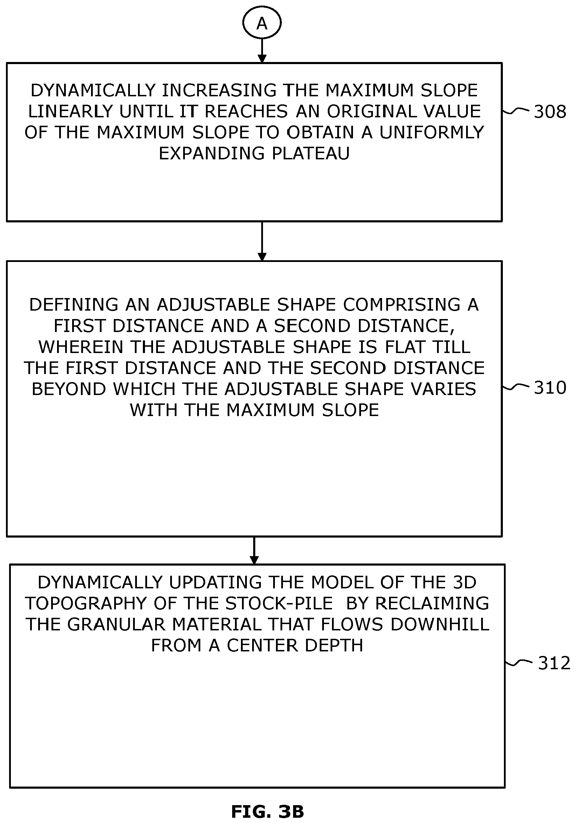

Referring to FIGS. 3A and 3B, illustrated is a flow diagram of a method of dynamically constructing and updating the model of 3-dimensional topography of the stock-pile of the granular material in accordance with an embodiment of the present disclosure. At step **302**, the method comprises retrieving a digital scan of the stock-pile at a software using a network, wherein the digital scan is recorded by a scanning device at the stock-pile. At step **304**, the method comprises dumping the granular material to a maximum slope in a column in the stock-pile, wherein the maximum slope is determined by analyzing digital scans of the stock-pile. At step **306**, the method comprises reducing the maximum slope to a smaller value of the maximum slope based on a distance between the column and a first column that is used to initially dump the granular material. At step **308**, the method comprises dynamically increasing the maximum slope linearly until it reaches the original value of the maximum slope to obtain a uniformly expanding plateau. At step **310**, the method comprises defining an adjustable shape comprising a first distance and a second distance, wherein the adjustable shape is flat till the first distance and the second distance beyond which the adjustable shape varies with the maximum slope. At step **312**, dynamically updating the model of the 3D topography of the stock-pile by reclaiming the granular material that flows downhill from a center depth.

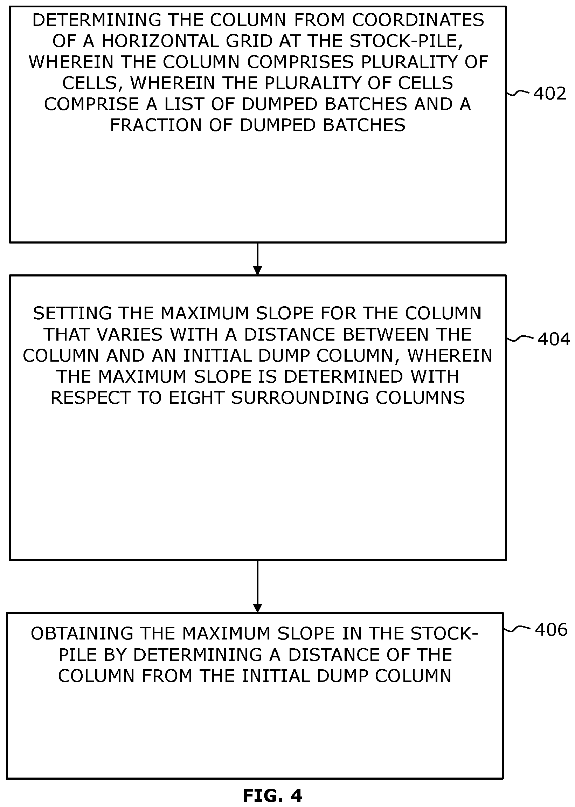

Referring to FIG. 4, illustrated is a flow diagram of a method of determining the maximum slope in the stock-pile in accordance with an embodiment of the present disclosure. At step **402**, the method comprises determining the column from coordinates of a horizontal grid at the stock-pile, wherein the column comprises a plurality of cells, wherein the plurality of cells comprises a list of dumped batches and a fraction of dumped batches. At step **404**, the method comprises setting the maximum slope for the column that varies with a distance between the column and an initial dump column, wherein the maximum slope is determined with respect to eight surrounding columns. At step **406**, obtaining the maximum slope in the stock-pile by determining a distance of the column from the initial dump column.

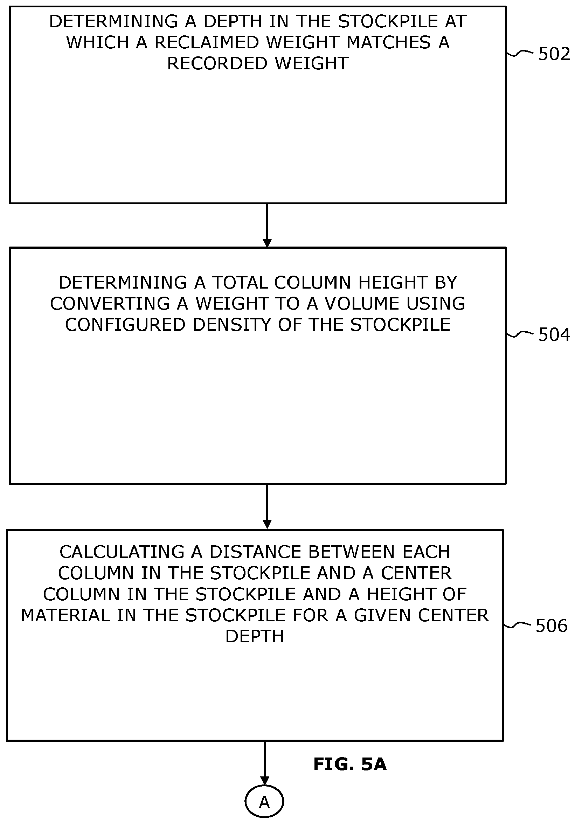

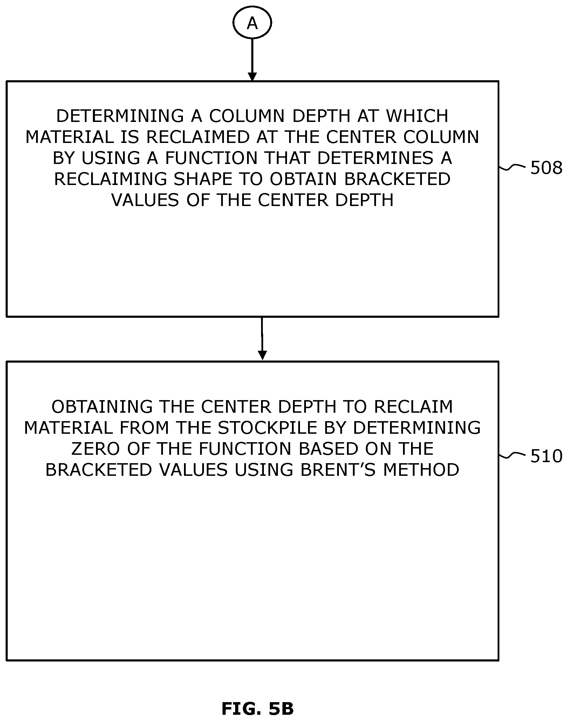

Referring to FIGS. 5A and 5B, illustrated is a flow diagram of a method determining the center depth to reclaim material from the stockpile in accordance with an embodiment of the present disclosure. At step **502**, the method comprises determining a depth in the stockpile at which a reclaimed weight matches a recorded weight. At step **504**, the method comprises determining a total column height by converting a weight to a volume using a configured density of the stockpile. At step **506**, the method comprises calculating a distance between each column in the stockpile and a center column in the stockpile and a height of material in the stockpile for a given center depth. At step **508**, the method comprises determining a column depth at which material is reclaimed at the center column by using a function that determines a reclaiming shape to obtain bracketed values of the center depth. At step **510**, the method comprises obtaining the center depth to reclaim material from the stockpile by determining zero of the function based on the bracketed values using brent's method.

Modifications to embodiments of the present disclosure described in the foregoing are possible without departing from the scope of the present disclosure as defined by the accompanying claims. Expressions such as "including", "comprising", "incorporating", "have", "is" used to describe and claim the present disclosure are intended to be construed in a non-exclusive manner, namely allowing for items, components or elements not explicitly described also to be present. Reference to the singular is also to be construed to relate to the plural.

## Claims

1. A method for dynamically constructing and updating a model of a 3D topography of a stock-pile of a granular material, the method comprising:
- retrieving a digital scan of the stock-pile at a software using a network, wherein the digital scan is recorded by a scanning device at the stock-pile;
- dumping the granular material to a maximum slope in a column in the stock-pile, wherein the maximum slope is determined by analyzing digital scans of the stock-pile;
- reducing the maximum slope to a smaller value of the maximum slope based on a distance between the column and a first column that is used to initially dump the granular material;
- dynamically increasing the maximum slope linearly until it reaches an original value of the maximum slope to obtain a uniformly expanding plateau;
- defining an adjustable shape comprising a first distance and a second distance, wherein the adjustable shape is flat till the first distance and the second distance beyond which the adjustable shape varies with the maximum slope; and
- dynamically updating the model of the 3D topography of the stock-pile by reclaiming the granular material that flows downhill from a center depth.

2. The method of claim 1, wherein the maximum slope in the stock-pile is determined by:
- determining the column from coordinates of a horizontal grid at the stock-pile, wherein the column comprises a plurality of cells, wherein the plurality of cells comprise a list of dumped batches and a fraction of dumped batches;
- setting the maximum slope for the column that varies with a distance between the column and an initial dump column, wherein the maximum slope is determined with respect to eight surrounding columns; and
- obtaining the maximum slope in the stock-pile by determining a distance of the column from the initial dump column.

3. The method of claim 1, wherein determining the center depth to reclaim material from the stockpile further comprises:
- determining a depth in the stockpile at which a reclaimed weight matches a recorded weight;
- determining a total column height by converting a weight to a volume using configured density of the stockpile;
- calculating a distance between each column in the stockpile and a center column in the stockpile and a height of material in the stockpile for a given center depth;
- determining a column depth at which material is reclaimed at the center column by using a function that determines a reclaiming shape to obtain bracketed values of the center depth; and
- obtaining the center depth to reclaim material from the stockpile by determining zero of the function based on the bracketed values using brent's method.

4. A processor-based method of dynamically updating a model of a 3D topography of a stock-pile location, the method comprising:
- retrieving a digital scan of a stock-pile using a network, wherein the digital scan is recorded by a scanning device at the stock-pile that comprises a horizontal grid, the horizontal grid further comprising one or more columns that are used to dump the granular material to a maximum slope in the stock-pile, the one or more columns lying between eight surrounding columns, wherein the one or more columns further comprise a list of cells that comprises information about a set of batches that are dumped into the one or more columns; and
- a software that performs :
- dumping the granular material to the maximum slope in a column in the stock-pile, wherein the maximum slope is determined by analyzing digital scans of the stock-pile;
- reducing the maximum slope to a smaller value of the maximum slope based on a distance between the column and a first column that is used to initially dump the granular material;
- dynamically increasing the maximum slope linearly until it reaches an original value of the maximum slope to obtain a uniformly expanding plateau;
- defining an adjustable shape comprising a first distance and a second distance, wherein the adjustable shape is flat till the first distance and the second distance beyond which the adjustable shape varies with the maximum slope; and
- dynamically updating the model of the 3D topography of the stock-pile by reclaiming the granular material that flows downhill from a center depth.

5. A system of dynamically constructing and updating a model of a 3D topography of a stock-pile of a granular material, the system comprising:
a network that is at least one of a wireless network or a wired network;
a scanning device connected to the network that is configured to record a digital scan of a location that comprises the stockpile and transmit the digital scan in the network;
a software connected to the network that comprises:
a dumping module configured to retrieve a digital scan of the stock-pile at a software, wherein the digital scan is recorded by a scanning device at the stock-pile; dumps a granular material to the maximum slope in a column in the stock-pile, wherein the maximum slope is determined by analyzing digital scans of the stock-pile; reduces the maximum slope to a smaller value of the maximum slope based on a distance between the column and a first column that is used to initially dump the granular material; and dynamically increasing the maximum slope linearly until it reaches an original value of the maximum slope to obtain a uniformly expanding plateau, the dumping module further comprising a maximum slope module to determine the maximum slope in the stock-pile; and
a reclaiming module configured to define an adjustable shape comprising a first distance and a second distance, wherein the adjustable shape is flat till the first distance and the second distance beyond which the adjustable shape varies with the maximum slope; and dynamically updating the model of the 3D topography of the stock-pile by reclaiming the granular material that flows downhill from a center depth, the reclaiming module further comprising a center depth module that determines the center depth to reclaim material from the stockpile.
